(19) Europäisches Patentamt
European Patent Office
Office européen des brevets

(11) **EP 1 653 280 A1**

(12) **EUROPEAN PATENT APPLICATION**
published in accordance with Art. 158(3) EPC

(43) Date of publication:
**03.05.2006 Bulletin 2006/18**

(51) Int Cl.:
***G03F 7/00*** (1968.09)

(21) Application number: **04745543.1**

(22) Date of filing: **03.06.2004**

(86) International application number:
**PCT/JP2004/007687**

(87) International publication number:
**WO 2005/015317 (17.02.2005 Gazette 2005/07)**

(84) Designated Contracting States:
**DE SE**

(30) Priority: **06.08.2003 JP 2003206288**

(71) Applicant: **SHARP KABUSHIKI KAISHA**
**Osaka-shi, Osaka 545-8522 (JP)**

(72) Inventors:
• **KOKUBO, Fumio**
  **Shiki-gun,**
  **Nara 636-0247 (JP)**

• **NISHIKAWA, Masayuki**
  **Higashiosaka-shi,**
  **Osaka 577-0825 (JP)**

(74) Representative: **Müller, Frithjof E.**
**Müller Hoffmann & Partner**
**Patentanwälte**
**Innere Wiener Strasse 17**
**81667 München (DE)**

(54) **PATTERN EXPOSING SYSTEM AND PATTERN EXPOSING METHOD**

(57) A pattern exposing apparatus includes a plurality of optical units, a control section sending to each optical unit a signal for controlling an exposure pattern width to be exposed according to pattern data concerning a target exposure pattern, and a compensation operation memory 24 for compensating the control signal sent from the control means to each optical unit according to the characteristics of each optical unit. In the pattern exposing apparatus including a plurality of optical units, a pattern faithful to a target pattern can be exposed regardless of the characteristics of each optical unit.

FIG. 1

## Description

TECHNICAL FIELD

The present invention relates to a pattern exposing apparatus and a pattern exposing method for performing exposure for a wiring pattern on a substrate.

BACKGROUND ART

In recent years, various kinds of flat type display apparatuses have been proposed. Examples of these flat type display apparatuses include liquid crystal panels, plasma display panels, and the like. It has been tried to give such flat type display apparatuses a larger screen size and better definition. It is considered that high definition requires resolution of about 0.5μm.

Moreover, an example of a method for forming a micro-sized pattern in order of submicron is a reduction projection exposing method in which a mask pattern is projected on a substrate and exposed in a reduced manner.

However, in the reduction projection exposing method, a narrower focal depth of a condensing lens for exposure is needed for higher resolution. This leads to a defocus due to a curve on a panel substrate within an exposure field.

Therefore, the reduction projection exposing method has a problem in that a desired pattern can not be obtained. Especially, for pattern exposure on a panel substrate for a flat type display apparatus, the exposure is carried out in a short time with respect to a large panel substrate in which an exposure field is set to be broad and which has such a size that one side thereof is more than 1m. Therefore, the defocus caused by a curve of the panel substrate becomes unignorable.

To solve the problem, a pattern exposing apparatus has been proposed, in which a convergent laser beam is irradiated on the panel substrate according to CAD data such as a wiring pattern. In other words, a pattern exposing apparatus employing a direct lithography method has been proposed. Moreover, the pattern exposing apparatus employing a direct lithography method is disclosed in Patent Document 1.

(Patent Document 1)

Japanese Laid-Open Patent Application No.
5-290720/1993 (Tokukaihei 5-290720; published on November 5, 1993)

The pattern exposing apparatus disclosed in Patent Document 1 includes (i) a condensing lens for condensing laser light on a photosensitive material applied on a panel substrate, the laser light emitted from a laser light source (ii) a focus error signal detection apparatus for measuring a distance between the condensing lens and the photosensitive material, and (iii) an actuator which moves the condensing lens in an optical axial direction. Then, the pattern exposing apparatus performs focus servo so as to keep a constant distance between the condensing lens and the photosensitive material. The focus servo allows to perform the exposure in which, despite curves on the panel substrate, the laser light passed through the condensing lens focuses on the photosensitive material. This makes it possible to obtain a uniform pattern.

However, the exposure apparatus disclosed in Patent Document 1 only has one laser source (for example, a semiconductor laser) and one condensing lens, and thus has a problem in that an exposure process for a large panel substrate requires very long time.

In this connection, in order to speed up the exposure process, an arrangement including a plurality of optical systems is also possible. This arrangement allows to expose a plurality of patterns at the same time. Such exposure apparatus including a plurality of optical systems is disclosed for example in Patent Document 2.

(Patent Document 2)

Japanese Laid-Open Patent Application No.
2000-214597 (published on August 4, 2000)

Moreover, the pattern exposing apparatus disclosed in Patent Document 1 may be so arranged as to include a plurality of optical units each of which has a laser source and a condensing lens. This arrangement allows to expose in a plurality of patterns at the same time.

However, when a plurality of optical units is provided, shapes of the light beams outputted from the respective optical units are not uniform, because each optical unit has different characteristics. Therefore, even if each optical unit has the same target pattern width to be exposed, the width of pattern (pattern width) to be formed by exposure performed by the respective optical units are not uniform in reality. Here, the term "characteristics of each optical unit" refers to characteristics of each of the laser sources or error in positional adjustment of each optical unit, characteristics of an optical element provided in each optical unit, and the like.

Therefore, the pattern exposing apparatus including a plurality of optical units, due to the difference in characteristics of each optical unit (the uneven characteristics of each optical unit), has a problem in that the exposure cannot be performed in accordance with a pattern faithful to pattern data concerning a target exposure pattern.

The present invention is to solve the above mentioned problems and an object of the present invention is to provide a pattern exposing apparatus and a pattern exposing method, by each of which the pattern exposing apparatus comprising a plurality of optical units can perform the exposure in accordance with patterns faithful to pattern data regardless of the uneven characteristics of each optical unit, the pattern data concerning target exposure patterns.

DISCLOSURE OF INVENTION

To attain the object, in accordance with the present invention, a pattern exposing apparatus includes: (I) optical units, each of which has (i) a light source for emitting laser light for exposure in a scanning manner and (ii) a light condensing lens for condensing the laser light onto a photosensitive material applied on a panel substrate; and (II) a control section for transmitting, respectively to each optical unit, a control signal according to pattern data concerning a target exposure pattern, the control signal being for controlling a width of pattern to be formed by exposure, each optical unit respectively exposing the photosensitive material in accordance with a pattern according to the control signal in the scanning manner, the pattern exposing apparatus further including a compensation section for compensating individually the control signals according to characteristics of the corresponding optical units, the control signals being to be transmitted from the control section to the corresponding optical units.

The pattern exposing apparatus includes the plurality of optical units. Here, each optical unit has variation in characteristics of the light source. Moreover, each optical unit has variation in the adjustment errors in positioning an optical element in each optical unit. Furthermore, characteristics of the optical element provided in each optical unit are various. Here, the characteristics of the light source, the adjustment error in positioning each optical element, and the characteristics of the optical element are dependent on the characteristics of each optical unit. The variation (non-uniformity) in characteristics of the respective optical units cause variation in widths of patterns to be formed by exposure performed by the respective optical units.

Therefore, it can be said that if a plurality of optical unit is provided without including a section for compensating characteristics of the respective optical units, exposure in a pattern faithful to the pattern data cannot be performed on the panel substrate.

In order to attain the object, the above mentioned arrangement includes a compensation section, which compensates the control signal to be sent from the control section to each optical unit according to the characteristics of each optical unit. Thus, in each optical unit, the width of pattern to be formed by exposure is adjusted according to the control signal which is compensated according to its characteristics.

This allows each optical unit to adjust, according to the control signal in which the characteristics of each optical unit are compensated, the width of pattern to be formed by exposure. Hereby, it is possible to perform exposure on the panel substrate in a pattern faithful to the pattern data, regardless of the characteristics of each optical unit.

A method in accordance with the present invention is a pattern exposing method for exposing a photosensitive material in accordance with a pattern in a scanning manner by using a pattern exposing apparatus including a plurality of optical units having (i) a light source for emitting laser light for the exposure in the scanning manner and (ii) a light condensing lens for condensing the laser light onto the photosensitive material applied on a panel substrate. To attain the object, the method includes the steps of: transmitting, respectively to each optical unit, a control signal according to pattern data concerning a target exposure pattern, the control signal being for controlling a width of pattern to be formed by exposure; and compensating individually the control signals according to characteristics of the corresponding optical units, the control signals being to be transmitted from the control section to the corresponding optical units.

The pattern exposing apparatus includes the plurality of optical units. Here, each optical unit has variation in characteristics of the light source. Moreover, each optical unit has variation in the adjustment errors in positioning an optical element in each optical unit. Furthermore, characteristics of the optical element provided in each optical unit are various. Here, the characteristics of the light source, the adjustment error in positioning each optical element, and the characteristics of the optical element are dependent on the characteristics of each optical unit. The variation (non-uniformity) in characteristics of the respective optical units cause variation in widths of patterns to be formed by exposures performed by the respective optical units.

Therefore, it can be said that if a plurality of optical unit is provided without having the step of compensating characteristics of the respective optical units, exposure in a pattern faithful to the pattern data cannot be performed on the panel substrate.

To attain object, the above mentioned procedure includes the step of compensating individually the control signals according to characteristics of the corresponding optical units, the control signals being to be transmitted from the control section to the corresponding optical units. Thus, each optical unit adjusts, according to the control signal which is compensated according to its characteristics respectively, width of pattern to be formed by exposure.

This allows each optical unit to adjust, according to the control signal in which the characteristics of each optical unit are compensated, the width of pattern to be formed by exposure. Hereby, it is possible to perform exposure on the panel substrate in a pattern faithful to the pattern data, regardless of the characteristics of each optical unit.

Further objects, characteristics and advantages of the present invention will be fully understood from descriptions below. Moreover, benefits of the present invention will be clearly described below with reference to the accompanying drawings.

BRIEF DESCRIPTION OF DRAWINGS

Figure 1 is a perspective view schematically illustrating an arrangement of a pattern exposing apparatus according to an embodiment of the present invention.

Figure 2 is an illustration illustrating an internal arrangement of an optical unit provided in the pattern exposing apparatus illustrated in Figure 1.

Figure 3 is an illustration illustrating a second light-receiving element provided in the optical unit illustrated in Figure 2, the second light-receiving element receiving a beam which is in a focusing state.

Figure 4 is an illustration illustrating the second light-receiving element provided in the optical unit illustrated in Figure 2, the second light-receiving element receiving a bean which is in a defocus state.

Figure 5 is an illustration illustrating two shapes of beams on a photosensitive material, the two shapes of beams being different in amount of defocus, and shapes of patterns (resists) formed on the photosensitive material by the two shapes of beams.

Figure 6 is a graph illustrating the relationship between an amount of defocus and a voltage of an FES.

Figure 7 is a graph illustrating the relationship between a voltage of an FES where an offset voltage V' is applied, and an amount of defocus.

Figure 8 is a diagram illustrating a change in a beam form of an FES as light quantity reflected on a panel substrate changes.

Figure 9 is an illustration illustrating two beam forms on a photosensitive material, the two beams being different in output intensity, and shapes of patterns (resists) formed on the photosensitive material by the two shapes of beams.

Figure 10 is an explanatory illustration illustrating a method for exposing an arbitrary exposure pattern.

Figure 11 is an illustration illustrating a form of a light beam whose light exposure does not expose the photosensitive material

Figure 12 is an illustration illustrating a shape of laser light whose output intensity is very low, and a shape of resist formed by the shape of the laser light on the photosensitive material.

Figure 13 is an illustration illustrating an internal arrangement of an optical unit according to another embodiment of the present invention.

BEST MODE FOR CARRYING OUT THE INVENTION

[Embodiment 1]

With reference to the accompanying drawings, a pattern exposing apparatus according to an embodiment of the present invention will be explained as follows.

(Brief Explanation on Arrangement Of Pattern Exposing Apparatus)

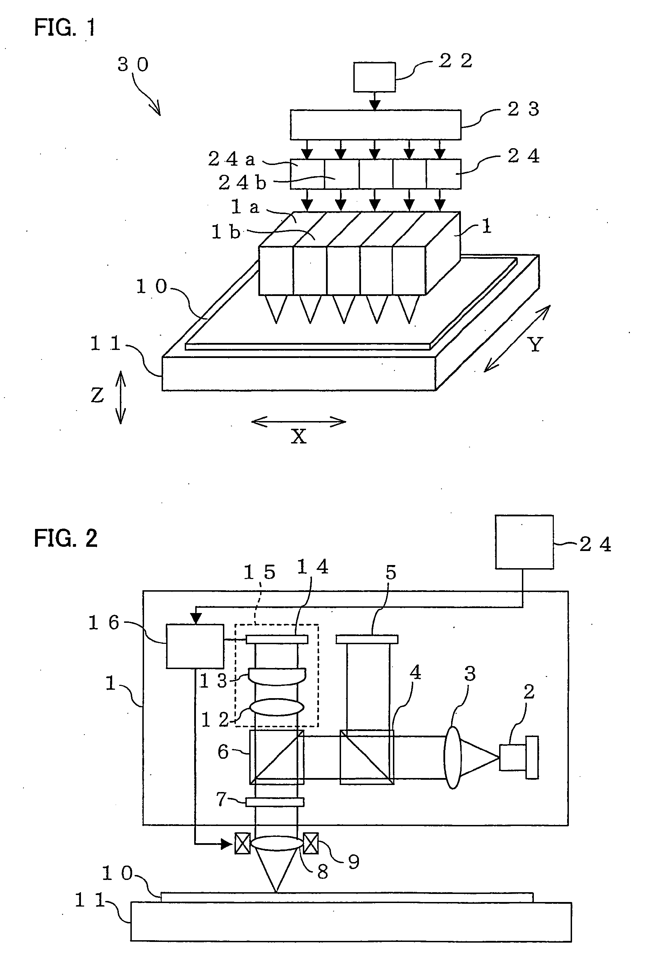

Fig. 1 schematically illustrates an arrangement of a pattern exposing apparatus 30 according to Embodiment 1. As illustrated in Fig. 1, the pattern exposing apparatus 30 includes a plurality of optical units 1, an XYZ stage 11, a panel substrate 10, data transfer means 22, control means 23, a plurality of compensation operation memories (compensation means) 24.

The XYZ stage 11 is a rectangular stage. Directions of sides thereof are an x direction, a y direction and a z direction respectively. The XYZ stage 11 is for mounting the panel substrate 10 thereon. In Embodiment 1, as illustrated in Fig. 1, the X direction is a direction parallel to a width direction of a base of the XYZ stage 11, the Y direction is a direction parallel to a length direction of the base of the XYZ stage 11, the Z direction is a direction vertical to the X direction and the Y direction. The XYZ stage 11 is movable in the X direction or in the Y direction. This allows the panel substrate 10 to be scanned in the X direction or in the Y direction. In Embodiment 1, the XYZ stage 11 on which the panel substrate 10 is mounted is moved. However, it may be arranged such that the XYZ stage 11 is in a fixed position and each optical unit 1 is moved.

The panel substrate 10 on which a photosensitive material is applied is mounted on the XYZ stage 11 such that a surface thereof on which the photosensitive material is applied faces the optical unit 1.

The data transfer means (data transfer circuit) 22 is an apparatus for externally receiving data concerning an exposure target pattern (desired pattern) (hereinafter referred to as "pattern data"), and for transferring the pattern data to the control means 23. The pattern data, which is created using a CAD system, indicates a wiring pattern which is to be formed on the panel substrate. The pattern data created using the CAD system is transferred by the data transfer means 22 to the control means 23.

The control means (control circuit) 23 is a circuit for outputting to an optical unit 1 a control signal for controlling a width of pattern to be formed by exposure, the control signal being according to the pattern data transferred from the data transfer means 22. In short, the control means 23 respectively generates different control signals for each optical unit 1, and respectively sends the different control signals to each optical unit 1.

Each compensation operation memory (lookup table, compensation means) 24 is a circuit for compensating the control signals being respectively sent from the control means 23 to the optical units 1 according to the characteristics of the corresponding optical units 1. Here, the compensation operation memories 24 respectively correspond to the optical units 1. Each compensation operation memory 24 stores therein compensation data according to the characteristics of the optical unit corresponding thereto.

In the arrangement according to Embodiment 1, a plurality of compensation operation memories 24 as compensation means is provided, but it may be arranged such that compensation data which respectively correspond to each optical unit is stored in one compensation means.

The optical unit 1 is an apparatus for irradiating laser light on the photosensitive material applied on the panel substrate 10. The optical unit 1 irradiates the laser light on the photosensitive material in accordance with the control signal sent from the compensation operation memory 24 corresponding to the optical unit 1, so as to form a pattern on the photosensitive material.

In short, each optical unit 1 is respectively connected to each compensation operation memory 24, and each compensation operation memory 24 is connected to the control means 23. For example, in Fig. 1, the data transfer means 22, the control means 23, a compensation operation memory 24a and an optical unit 1a are cascade-connected in this order, and the data transfer means 22, the control means 23, a compensation operation memory 24b, and an optical unit 1b are cascade-connected in this order.

According to the control signal, the optical unit 1 controls a width of pattern to be formed by exposure. There are following two methods for controlling the pattern width. In a first method, the pattern width is adjusted by controlling the optical unit 1 according to the control signal so as to adjust a focus position of an optical system for condensing laser light on the photosensitive material. In a second method, the pattern width is adjusted by controlling the optical unit 1 according to the control signal so as to adjust intensity of the laser light. Here, the first method is described in Embodiment 1. The second method will be described in Embodiment 2.

According to the above-mentioned arrangement, the exposure of the photosensitive material on the panel substrate 10 is performed with the plurality of optical unit 1. Accordingly, a plurality of light condensing points is formed on a surface of the photosensitive material. Moreover, the exposure is performed on the panel substrate 10 being scanned in the X direction or in the Y direction. Therefore, one scan performed can cause the plurality of optical units 1 to expose to form a plurality of patterns on the photosensitive material on the panel substrate 10.

Further, in the above-mentioned arrangement, the control means 23 outputs the control signals that are to be inputted into the corresponding optical units 1. The output of each control signal is carried out according to the pattern data transferred from the data transfer means 22, and each control signal is respectively compensated by the corresponding compensation operation memory 24. Then, according to the compensated control signal, each optical unit 1 performs the exposure of the photosensitive material on the panel substrate 10 in a scanning manner. Here, each compensation operation memory 24 compensates the inputted control signal according to the characteristics of the corresponding optical unit. Therefore, the optical units 1 can perform the exposure of the photosensitive material respectively to form patterns faithful to the pattern data regardless of the characteristics thereof. Detailed descriptions for the optical unit 1 and the compensation operation memory 24 will be given below.

(Optical Unit)

With reference to Fig. 2, an arrangement of the optical unit 1 in the pattern exposing apparatus 30 of Embodiment 1 is described below.

The optical unit 1 includes a semiconductor laser (light source) 2, a collimator lens 3, a beam splitter (hereinafter referred to as "BS") 4, a first light-receiving element 5, a polarization beam splitter (hereinafter referred to as PBS) 6, a 1/4-wavelength plate 7, a first light condensing lens 8, an actuator 9, an error signal detection apparatus 15, and focus servo control means 16.

The optical unit 1 is arranged such that light emitted from the semiconductor laser 2 passes through the collimator lens 3, the BS 4, the PBS 6, the 1/4-wavelength plate 7, and the first light condensing lens 8 in this order, and the light is condensed on the photosensitive material on the panel substrate 10. The light condensed on the photosensitive material on the panel substrate 10 is reflected therefrom. The reflected light passes through the first light condensing lens 8, the 1/4-wavelength plate 7 and the PBS 6 in this order, and then enters the error signal detecting apparatus 15.

Next, each component of the optical unit 1 is described below in more details. The semiconductor laser 2 is a laser light source for emitting laser light to which the photosensitive material is sensitive. The collimator lens 3 is for shaping laser light emitted from the semiconductor laser 2 (for example, for shaping the laser light into light of parallel beams), and for guiding the shaped laser light into the BS 4.

The BS 4 is an optical element which reflects a part of the laser light from the collimator lens 3 to the first light-receiving element 5 and which lets the rest of the laser light pass therethrough and guides it to the PBS 6. The first light-receiving element 5 receives the laser light from the BS 4 thereby to monitor intensity of the laser light outputted from the semiconductor laser 2.

The PBS 6 is an optical element which guides the laser light from the BS 4 to the 1/4-wavelength plate 7 by reflecting the laser light. Meanwhile, the PBS 6 lets the reflected light pass therethrough, the reflected light reflected from the photosensitive material on the panel substrate 10. By doing this, the PBS 6 guides the reflected light to the error signal detection apparatus 15.

The 1/4-wavelength plate 7 is an optical element, by which light entered therein is so outputted that the outputted light has a 1/4-wavelength shift between phases of a polarization component which is in parallel direction to a crystal axis of the 1/4-wavelength plate and of a polarization component which is vertical to the crystal axis. In Embodiment 1, the laser light from the PBS 6 is converted from linear polarization light to circular polarization light by the 1/4-wavelength plate 7. On the other hand, the reflected light from the photosensitive material is converted from circular polarization light to linear polarization light by the 1/4-wavelength plate 7. In short, the 1/4-wavelength plate 7 shifts a polarization plane, whereby the output light passed through the 1/4-wavelength plate 7 is shifted by 90° in comparison with the incident light on the 1/4-wavelength plate 7.

The first light condensing lens 8 condenses light from the 1/4-wavelength plate 7 on the photosensitive material on the panel substrate 10.

The error signal detection apparatus (focus error detection means) 15 is a unit for outputting a focus error signal (hereinafter referred to as FES) indicating a focus error of the first light condensing lens 8 according to the light reflected on the photosensitive material on the panel substrate 10 and passed through the first light condensing lens 8, the 1/4-wavelength plate 7, and the PBS 6.

The focus serve-control means 16 drives the actuator 9 according to the FES to perform focus servo. As described later, here in Embodiment 1, the compensation operation memory 24 is connected to the focus servo-control means 16, which is provided in the optical unit 1 corresponding to the compensation operation memory 24. The focus servo-control means 16 adjusts the offset voltage according to the control signal, and adds the adjusted offset voltage to the FES thereby to perform the focus servo.

Controlled by the focus servo-control means 16, the actuator 9 moves the first light condensing lens 8 in the optical axial direction, and adjusts a distance between the photosensitive material and the first light condensing lens 8.

Referring to Fig. 2 to Fig. 4, the following will describe a procedure for detecting the FES using the error signal detection apparatus 15. Examples of an FES detection method include an astigmatic method, a knife-edge method, etc. In Embodiment 1, an arrangement in which the astigmatic method is used to detect the FES will be described. It should be noted that an arrangement in which the knife-edge method is used to detect the FES is also possible.

As shown in Fig. 2, the error signal detection apparatus 15 includes a second light condensing lens 12, a cylindrical lens 13, and a second light-receiving element 14. Specifically, on the light axis of the light reflected on the photosensitive material on the panel substrate 10, the first light condensing lens 8, the 1/4-wavelength plate 7, the PBS 6, the second light condensing lens 12, the cylindrical lens 13, and the second light-receiving element 14 are arranged in this order.

The second light condensing lens 12 condenses, on the second light-receiving element 14, the light which is reflected from the photosensitive material and passed through the first light condensing lens 8, the 1/4-wavelength plate 7, and the PBS 6. The cylindrical lens 13 condenses one direction of light from the second light condensing lens 12, in order to astigmatize the light.

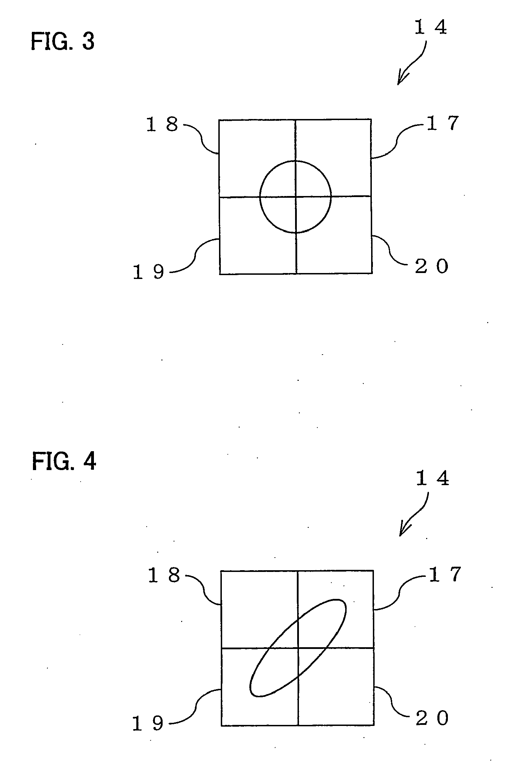

As shown in Fig. 3, the second light-receiving element 14 is a so-called tetrametric light-receiving element whose light-receiving surface is divided into four. The second light-receiving element 14 receives the light passed through the second light condensing lens 12 and the cylindrical lens 13 (the reflected light from the photosensitive material on the panel substrate 10) on each light-receiving surface, and converts, into an electronic signal, the light received on each light-receiving surface.

Here, four light-receiving surfaces divided are referred to as a first light-receiving surface 17, a second light-receiving surface 18, a third light-receiving surface 19, and a fourth light-receiving element 20 respectively. The first light-receiving surface 17 and the third light-receiving surface 19 are in a diagonal relationship, and the second light-receiving surface 18 and the fourth light-receiving surface 20 are in a diagonal relationship.

Therefore, the FES can be obtained from:

$$FES = (P1 + P3) - (P2 + P4)$$

where P1 is an output signal from the first light-receiving surface 17, P2 is an output signal from the second light-receiving surface 18, P3 is an output signal from the third light-receiving surface 19, and P4 is an output signal from the fourth light-receiving surface 20.

Here, a positional relationship among the second light condensing lens 12, the cylindrical lens 13, and the second light-receiving element 14 is set such that a circular pattern form of light is obtained on the second light-receiving element 14 when the focal point of the first light condensing lens 8 is on the photosensitive material applied on the panel substrate 10. In this case, the four light-receiving surfaces receive the same amount of light, so that the outputs of the four light-receiving surfaces are equal. Therefore, the FES is 0.

On one hand, the positional relationship among the second light condensing lens 12, the cylindrical lens 13, and the second light-receiving element 14 is set such that when the distance between the first light condensing lens 8 and the photosensitive material is more than the focal distance of the first light condensing lens 8, an oval pattern form is obtained on the second light-receiving element 14, as illustrated in Fig. 4, and the amount of light received on the first light-receiving surface 17 and the third light-receiving surface 19 is more than the amount of light received on the second light-receiving surface 18 and the fourth light-receiving surface 20. In this case, the output of each light-receiving element by the reflected light is:

$$(P1=P3)>(P2=P4),$$

and
FES is positive.

On the other hand, the positional relationship among the second light condensing lens 12, the cylindrical lens 13, and the second light-receiving element 14 is set such that when the distance between the first light condensing lens 8 and the photosensitive material is less than the focal distance of the first light condensing lens 8, the output of each light-receiving element by the reflected light is:

$$(P2=P4)>(P1=P3),$$

and
the FES is negative.

The error detection apparatus 15 may be arranged such that the FES is negative when the distance between the first light condensing lens 8 and the photosensitive material is more than the focal distance of the first light condensing lens 8, and the FES is positive when the distance between the first light condensing lens 8 and the photosensitive material is less than the focal distance of the first condensing lens 8.

(Compensation operation Memory)

As can be seen from the above description, the pattern exposing apparatus 30 of Embodiment 1 is arranged such that it includes a plurality of optical units 1. If the pattern exposing apparatus 30 was not include each compensation operation memory 24, the form of laser light outputted from each optical unit 1 would not be uniform, even if currents applied to the semiconductor laser 2 are the same and the focus servo is adjusted for allowing the FES to be 0 in all the optical units 1, resulting in variation in the widths of patterns to be formed by exposure by the optical unit 1. That is, even if each optical unit has the same target width of pattern to be formed by exposure, the widths of pattern to be formed by exposure by the respective optical units in reality are not uniform.

The reason is that there is variation among characteristics of the semiconductor lasers 2 of the optical units 1, and each optical unit 1 has variation in positional adjustment errors in fixing optical element therein. Furthermore, characteristics of the optical element provided in each optical unit are not uniform. In this Specification of the present application, the characteristics of the semiconductor laser 2, the positional adjustment errors in fixing each optical element, and the characteristics of the optical element are referred to the "characteristics of each optical unit". Variation in widths of patterns to be formed by exposure by each optical unit 1 is referred to "exposure non-uniformity". The variation in pattern widths is caused by variations in the characteristics of each optical unit.

That is, it can be said that, if the pattern exposing apparatus 30 is provided with the plurality of optical units 1 without compensation means for compensating such exposure non-uniformity, each optical unit 1 can not expose to form, on the panel substrate 10, a pattern faithful to the pattern data.

In this regard, Embodiment 1 is provided with the compensation operation memory 24, which compensates, according to the characteristics of each optical unit 1, the control signal sent from the control means 23 to each optical unit 1. That is, each compensation operation memory 24 stores compensation data according to the characteristics of each optical unit 1 connected to each compensation operation memory 24. The control signal is compensated according to the compensation data. When each optical unit 1 is set up, the compensation data is set according to the characteristics of each optical unit 1 so as to eliminate the exposure non-uniformity.

The following description discuses the setup. First, each optical unit 1 is allowed to actually perform exposure to form a pattern according to pattern data which is identical with each other in terms of the targeted exposure pattern width of each optical unit 1. Then, a control signal to be inputted to each optical unit 1 is multiplied by a coefficient in each case in order that each optical unit 1 actually performs the exposures in a uniform pattern. Coefficients thus calculated are stored as a compensation data in each compensation operation memory 24 corresponding to each optical unit 1.

With this, the pattern actually formed by the exposure of each optical unit will have a uniform pattern width when a target pattern width by each optical unit 1 is identical. Thus, each optical unit 1 can expose to form, on the panel substrate 10, a pattern faithful to the pattern data regardless of the characteristics of each optical unit.

(Adjustment Of Exposure pattern width)

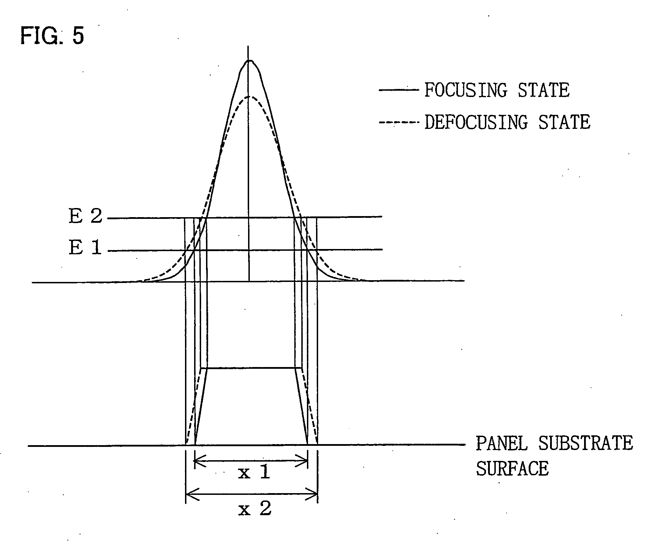

The following detailed description refers to adjustment of width of pattern to be formed by exposure. In the upper part in Figure 5, two shapes of laser light (these shapes are formed on a photosensitive material) are illustrated. The two beams of laser light are outputted respectively from two optical units 1 which have different focus positions. In the lower part in Figure 5, shape of patterns (cross-section of a resist formed on the panel substrate) exposed by the two beams of laser light is illustrated. Here, it is assumed that intensity of the laser light of the two optical units 1 is I1 identically.

Here, it is supposed that the laser light indicated by a solid line in Fig. 5 has a focus position on a surface of the photosensitive material, and it is supposed that the laser light indicated by a broken line in Fig. 5 has a focus position which is distanced from the surface of the photosensitive material by a distance d. That is, the laser light indicated by the solid line is in a focusing state, and the laser light indicated by the broken line is in a defocus state with a defocus amount d.

Here, it is put that the photosensitive material is a negative resist and the photosensitive material has a characteristic that a photo-reaction is initiated with the light exposure amount of E1, and is completed with the light exposure amount of E2.

From Fig. 5, it can be seen that, between the exposure in the light exposure amount E1 to the exposure in the light exposure amount E2, the beam width in the focusing state is narrower than the beam width in the defocusing state.

Fig. 5 indicates a developed pattern form. From Fig. 5, it can be seen that the pattern width x2 formed by the laser light in the defocusing state is wider than the pattern width x1 formed by the laser light in the focusing state. The exposure pattern widths x1 and x2 illustrated in Fig. 5 are measured on the surface of the panel substrate 10.

Here, if in order to equalize the pattern width x2 with the pattern width x1, the focus position of the first light condensing lens 8 arranged in any optical unit 1 is adjusted by the amount of defocus d, it is possible to form uniform widths of patterns by each of the optical units 1. In Fig. 5, the amount of defocus d is illustrated larger than the actual amount of defocus for the sake of easy explanation in the description of Embodiment 1. However, the amount of defocus d is actually very small.

The following description explains a method for adjusting the focus position of the first light condensing lens 8 by the amount of defocus d in the optical unit 1.

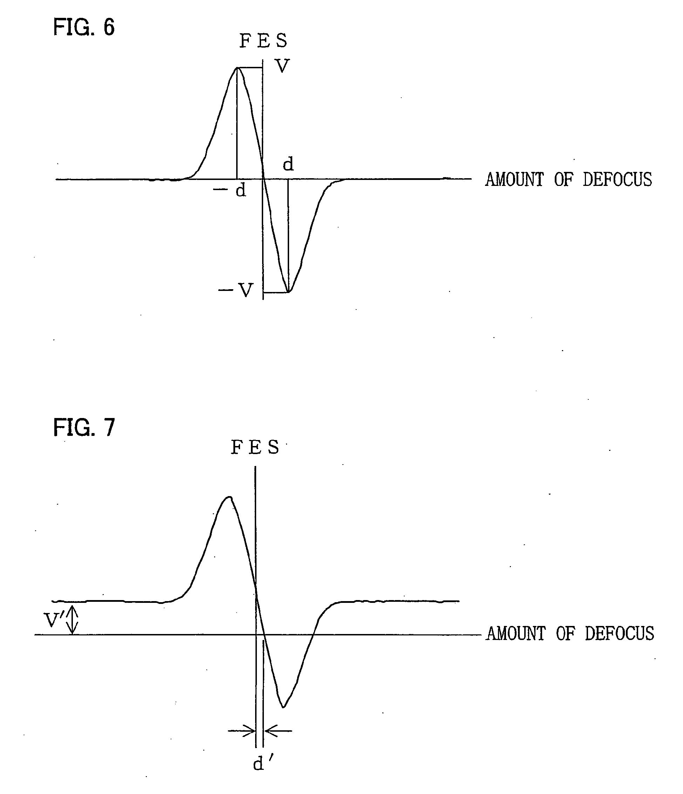

First, Fig. 6 is a graph of a characteristic curve illustrating a relationship between a voltage of the FES detected by the error signal detection apparatus 15 and an amount of defocus of the first light condensing lens 8. In Fig. 6, the horizontal axis indicates the amount of defocus, and a vertical axis indicates the voltage of the FES. Here, the focus servo control means 16 performs the focus servo by driving the actuator 9 such that the voltage of the FES becomes 0. As a result, the amount of defocus becomes 0.

Then, Fig. 7 illustrates a graph of a characteristic curve illustrating a relationship between a voltage of the FES and an amount of defocus. Here, different from the FES in Fig. 6, an offset voltage V' is added to this voltage of the FES. In Fig. 7, the horizontal axis indicates the amount of defocus, and the vertical axis indicates the voltage of the FES. Again, the focus servo control means 16 performs the focus servo by driving the actuator 9 such that the voltage of the FES becomes 0. As a result, the defocus amount becomes d'.

That is, the range of the amount of defocus of -d to d can be a target of the focus servo if a voltage in the range from -V to +V is added as an offset voltage V' to the FES in Fig. 6 (the voltage in the range from -V to +V correspond to an amount of defocus in the range from -d to d). This allows the distance between the first light condensing lens 8 and the photosensitive material on the panel substrate 10 to be adjusted, in the range of the amount of defocus of -d to d, for each optical unit 1.

Here, in Embodiment 1, it is arranged such that the compensation operation memory 24 is connected with the focus servo control means 16, and a control signal sent from the compensation operation memory 24 is inputted to the focus servo control means 16. With this arrangement, the focus servo control means 16 adjusts, according to the control signal, the offset voltage V' that is to be added to the FES. Then, the offset current which is adjusted according to the control signal is added to the FES so as to perform the focus servo. In this way, the width of pattern to be formed by exposure performed by the corresponding optical unit 1 is adjusted according to pattern data.

Here, in Embodiment 1, the control signal is compensated by the compensation operation memory 24. Therefore, a pattern faithful to the pattern data can be formed on the panel substrate 10 by the exposure regardless of the characteristics of each optical unit 1. That is, when each optical unit 1 aims to form the pattern with the same pattern width, each optical unit 1 can perform exposure to actually form the pattern with a uniform pattern width. Therefore, the pattern exposing apparatus 30 according to Embodiment 1 does not cause exposure non-uniformity when plural patterns are formed by laser light from a plural number of optical units 1. Accordingly, it is possible to form a pattern faithful to the pattern data.

As described so far, the focus servo control means 16 according to Embodiment 1 adjusts the offset voltage V' according to the control signal which is compensated by the compensation operation memory 24. Then, the focus servo control means 16 adds the adjusted offset voltage V' to the FES and performs the focus servo to set the FES to 0. However, the focus servo can be performed by setting the target voltage according to the control signal which is compensated by the compensation operation memory 24 in order to adjust the FES to the target voltage.

That is, the focus servo control means 16 may have any arrangement, provided that the focus servo control means 16 allows to adjust the focus position of the first light condensing lens 8 in the optical axial direction, according to (a) the FES detected by the error signal detection apparatus 15 and on (b) the control signal.

The method has been explained in which the focus servo allows each optical unit 1 to form a pattern faithful to the pattern data, regardless of the exposure incoherence of each optical unit 1. However, the method may include the following problems.

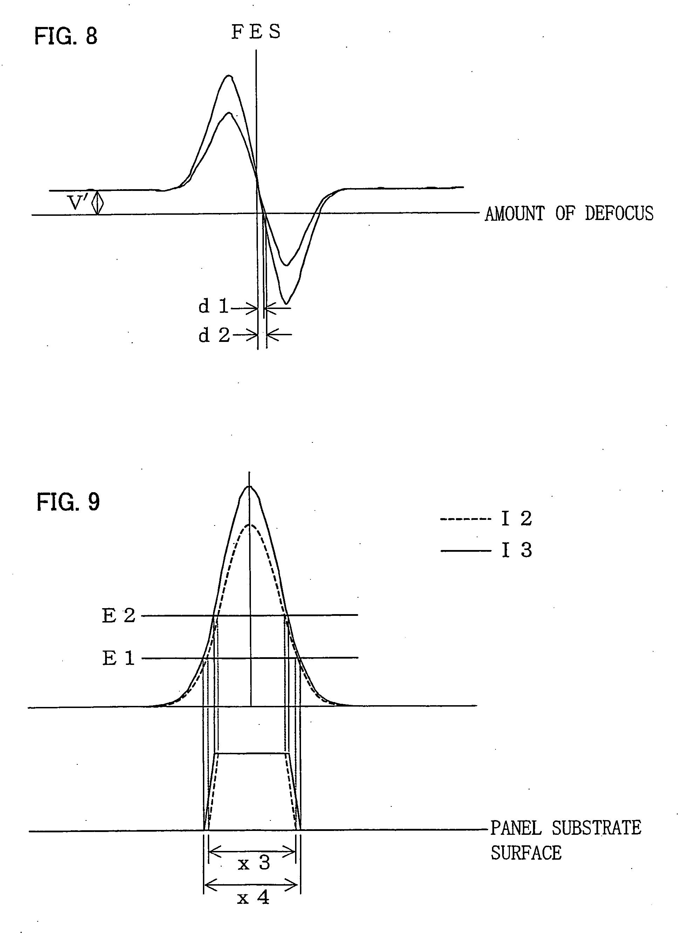

A metal film or the like is partially formed on the panel substrate 10 to form for example a thin film transistor or the like. Therefore, in practice, various types or forms of the metal film cause changes in an amount of light which is reflected from the panel substrate 10, and thus in an amount of light received in a second light-receiving element 14. The changes in an amount of light received in the second light-receiving element 14 cause changes in a signal amplitude of the FES as illustrated in Fig. 8. Due to the changes in a signal amplitude of the FES, as illustrated in Fig. 8, the target position of the focus servo changes from the amount of defocus d1 to the amount of defocus d2.

Specifically, there arises a problem such that the variety of types or forms of the metal film to which each optical unit 1 performs exposure leads to the changes in the distance between the first light condensing lens 8 and the photosensitive material.

Therefore, in order to avoid the above-mentioned problem, it is necessary to change the focus servo according to the amount of all light received by the second light-receiving element 14. That is, the focus servo control means 16 compensates the focus position of the first light condensing lens 8 according to the amount of all light received by the second light-receiving element 14. Specifically, it may be arranged such that the amount of all light received by the second light-receiving element 14 is multiplied by a predetermined coefficient so as to obtain an offset voltage V'. Alternatively, it may be arranged such that an offset voltage V' is added to a value obtained by dividing the FES by the amount of all light received. In either of these ways, it is possible to appropriately maintain the focus position of the first light condensing lens 8 and the position of the photosensitive material, even if the amount of reflected light changes.

[Embodiment 2]

Referring to drawings, another embodiment of the present invention is described below. In Embodiment 1, it is arranged such that the intensity of the semiconductor laser 2 in each optical unit 1 is fixed, and the position of the first light condensing lens 8 in each optical unit 1 is adjusted in the optical axial direction, so as to control each width of pattern to be formed by exposure. In contrast, in Embodiment 2, intensity of the semiconductor laser in each optical unit is variable, and the intensity of the semiconductor laser is adjusted in each optical unit, so as to control each width of pattern to be formed by exposure. In Embodiment 2, only arrangement different from Embodiment 1 is explained.

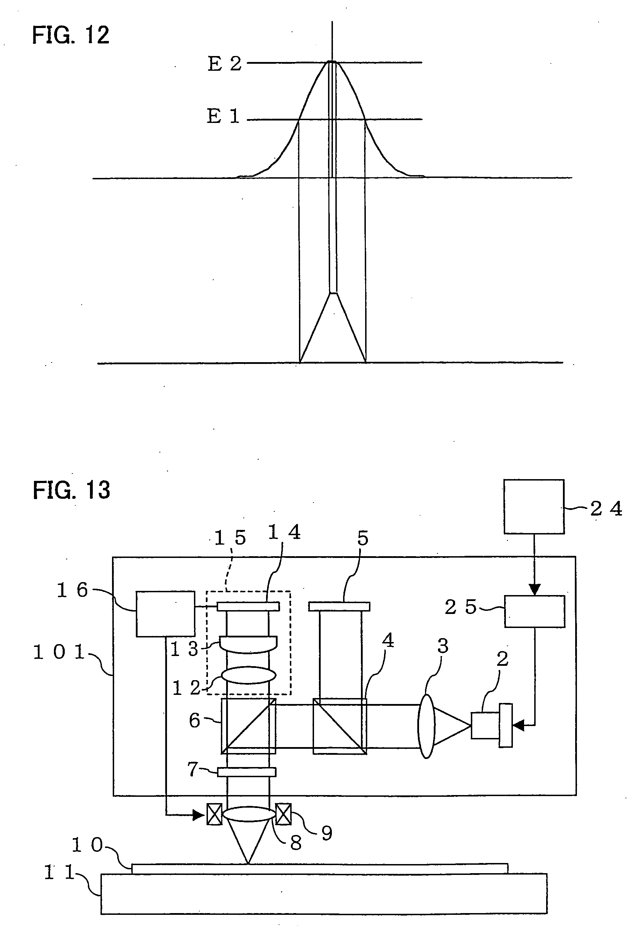

Fig. 13 illustrates an arrangement of an optical unit 101 according to Embodiment 2. The optical unit 101 illustrated in Fig. 13 is different from the optical unit 1 illustrated in Fig. 2 in that the optical unit 101 includes a laser driver (intensity changing means) 25 which is connected with a compensation operation memory 24 and a semiconductor laser 2. This laser driver 25 adjusts the current to be applied to the semiconductor laser 2 in accordance with the control signal sent from the compensation operation memory 24, so as to adjust the intensity of the laser light of the semiconductor laser 2.

(Adjustment of Exposure pattern width)

Next, how the width of pattern to be formed by exposure is adjusted according to Embodiment 2 will be described in detail. In the upper part in Fig. 9, two shapes of laser light (shapes of the laser light on a photosensitive material) are illustrated, the two light beams being different in intensity. In the lower part in Figure 9, pattern forms to be exposed by the laser light (a cross section of a resist formed on the panel substrate 10) are illustrated. In this Figure, intensity of the laser light indicated by broken lines is I2, and intensity of the laser light indicated by solid lines is I3.

Moreover, it is understand that the photosensitive material is a negative resist and has a characteristic that photo-reaction is initiated with the light exposure amount E1 and that the photo-reaction is completed with the light exposure amount E2.

Here, as shown in the lower part in Fig. 9, a pattern width formed by the laser light with the intensity of I2 is x3 and a pattern width formed by the laser light with the intensity of I3 is x4.

From Fig. 9, it can be understood that the pattern width formed by the laser light with the intensity of I2 is narrower than the pattern width formed by the laser light with the intensity of I3. That is, different intensities of the laser light lead to different widths of patterns to be formed by exposure.

Therefore, it is also possible to perform the exposure to form uniform pattern widths by adjusting the intensity of the laser light. Specifically, in each optical unit 101, a current to be applied to the semiconductor laser 2 is adjusted by the laser driver 25 in accordance with the control signal from the compensation operation memory 24. This makes it possible not only to form a pattern on the panel substrate 10 according to the pattern data, but also to adjust the width of pattern to be formed by exposure performed by each optical unit 101.

Moreover, the control signal is compensated by the compensation operation memory 24. Therefore, each optical unit 101 can perform the exposure to form a pattern faithful to the pattern data on the panel substrate 10 regardless of the characteristics of each optical unit 101. That is, when the target pattern widths targeted by each optical unit 101 are the same, each optical unit 101 can actually perform the exposure to form uniform pattern width.

The intensity of the semiconductor laser 2 can be more easily adjusted in an arrangement in which a first light-receiving element (monitor means) 5 monitors the laser light outputted from the semiconductor laser 2 and the laser driver 25 compensates the intensity of the laser light of the semiconductor laser 2 in accordance with the monitoring result from the first light-receiving element 5.

To adjust the pattern width, any one of methods described in Embodiment 1 and Embodiment 2 can be used. A method combining Embodiment 1 and Embodiment 2 may also be used.

[Embodiment 3]

Yet another embodiment of the present invention is explained below.

For actually forming a pattern on a photosensitive material, it is necessary to perform the exposure such that a pattern is drawn(formed) in a variety of forms. For this purpose, a method for exposing a pattern in an arbitrary form will be described in Embodiment 3. In Embodiment 3, only arrangement different from Embodiment 1 and Embodiment 2 is explained.

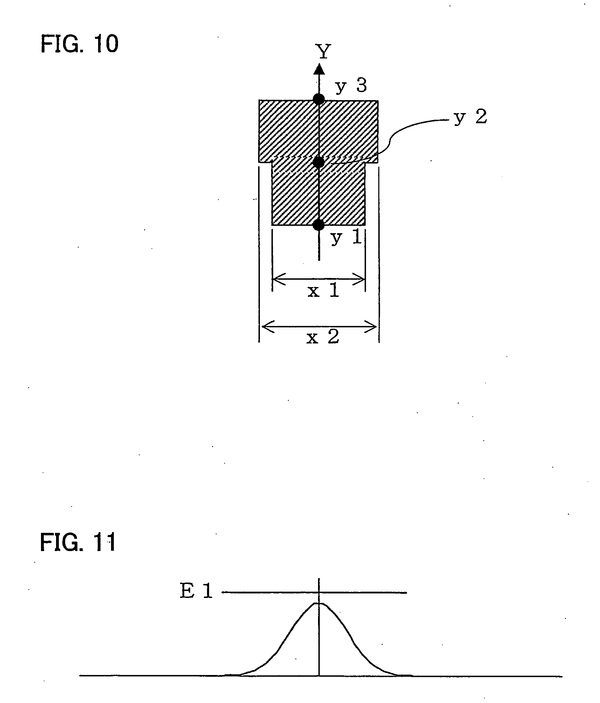

By way of example, explained below is an exposure method for drawing a pattern as illustrated in Fig. 10. Here, it is supposed that the panel substrate 10 is moved in the Y direction to perform a scan exposure.

First, it is supposed that the optical unit 1 exposes the photosensitive material to laser light with the intensity of I4. The intensity I4 is, as illustrated in Fig. 11, an intensity that gives an exposure amount E1 or less to the photosensitive material (the exposure amount E1 is an amount enough to cause the photosensitive material to be photo-reacted). That is, the intensity I4 is an intensity that is less than an intensity that causes the photosensitive material to be photo-reacted, i.e. an intensity that does not cause the photosensitive material to be photo-reacted.

Then, the photosensitive material is exposed to the laser light which is condensed on the position y1 on the panel substrate and whose intensity is adjusted to I1. The intensity I1 is an intensity that gives the photosensitive material an exposure amount enough to cause the photosensitive material to be photo-reacted (that is, an intensity that causes the photosensitive material to be photo-reacted).

At this time, the offset voltage to the FES remains 0. Then, when the laser light arrives at the position y2, the offset voltage V' is added to the FES, so as to perform the exposure to form a pattern with focus servo that targets the amount of defocus amount d'. Further, when the condensed light beam is arrived at the position y3, the intensity of the laser light is set to I4.

In this way, the offset voltage is accordingly changed according to the targeted pattern form. This makes it possible to obtain exposure patterns in various forms. In the same way, according to the target pattern form, the intensity of the laser light outputted by the semiconductor laser 2 is accordingly changed. This makes it possible to obtain exposure patterns in various forms.

Moreover, as described in the method for drawing exposure pattern, it is preferable that an area which is not to be exposed (for example an area up to the position y1 which is a starting point of the exposure) is previously irradiated with laser light with the intensity of I1, which is less than the light exposure amount E1, and it is preferable to previously perform the focus servo.

That is, in an arrangement in which whether the pattern exposure is carried out or not is controlled by turning on/off the semiconductor laser 2, it is necessary to carry out focusing after turning on the semiconductor laser 2. Thus, for a period which is necessary for focusing, the pattern exposure is not carried out even in an exposure position. In this case, scanning is continued during the period which is necessary for focusing. As a result such a problem arises that the scanning is performed on the exposure position without exposing in a pattern.

Therefore, in order to solve the above mentioned problem, it is preferable to control exposure/non-exposure of the pattern simply by the adjustment of the intensity of the laser light without turning off the semiconductor laser 2. In this case, it is possible to perform the focusing always during the scan exposure.

Moreover, it is preferable to arrange the optical unit 1 such that the width of pattern to be formed by exposure by the optical unit 1 in the focus state (focusing state) is narrower than the target minimum exposure pattern width. In other words, it is preferable that optical units 1 can form a pattern as small as possible. The reason for this will be explained below.

The width of the pattern to be formed on the photosensitive material by the exposure can be easily widened by defocusing the optical unit 1. On the other hand, narrowing the pattern width can be realized by adjusting the amount of defocus of the optical unit 1 close to 0. That is, a width of pattern to be formed by exposure by the optical unit 1 in the focusing state (defocus amount is 0) is the minimum width which can be formed by the exposure. Here, in the arrangement in which the exposure is carried out with a target minimum pattern in the focusing state, if the variation in semiconductor lasers 2 or the positional error in the optical elements degrades light condensing performance, the width of pattern to be formed by exposure in the focusing state is widened. This may lead to a disadvantage in that the exposure in the targeted minimum pattern cannot be attained.

Therefore, by arranging the optical unit 1 such that a width of pattern to be formed by the exposure by the optical unit 1 in the focusing state is narrower than the target minimum width of pattern to be formed by exposure, it is possible to prevent the above mentioned disadvantage.

If the intensity of the laser light outputted by the semiconductor laser 2 is lowered in order to narrow the pattern width of the pattern to be formed on the photosensitive material, an angle of a pattern wall becomes more gentle, as shown in Fig. 12, but no practical form of a pattern can be realized. Moreover, in this case, the formed pattern width is not so narrow.

It is preferable to arrange the optical unit 1 such that even if the variation in semiconductor lasers 2 or the positional error in the optical elements degrades light condensing performance, the light condensing performance is enough to perform the exposure to form the targeted minimum pattern, that is, the width of pattern to be formed by exposure by the optical unit 1 in the focus state (focusing state) is narrower than the target minimum exposure pattern width.

To solve the foregoing problems, in accordance with the present invention, a pattern exposing apparatus includes: (I) optical units, each of which has (i) a light source for emitting laser light for exposure in a scanning manner and (ii) a light condensing lens for condensing the laser light onto a photosensitive material applied on a panel substrate; and (II) a control section for transmitting, respectively to each optical unit, a control signal according to pattern data concerning a target exposure pattern, the control signal being for controlling a width of pattern to be formed by exposure, each optical unit respectively exposing the photosensitive material in accordance with a pattern according to the control signal in the scanning manner, the pattern exposing apparatus further comprising: a compensation section for compensating individually the control signals according to characteristics of the corresponding optical units, the control signals being to be transmitted from the control section to the corresponding optical units.

The pattern exposing apparatus comprises the plurality of optical units. Here, each optical unit has variation in characteristics of the light source. Moreover, each optical unit has variation in the adjustment errors in positioning an optical element in each optical unit. Furthermore, characteristics of the optical element provided in each optical unit are various. Here, the characteristics of the light source, the adjustment error in positioning each optical element, and the characteristics of the optical element are dependent on the characteristics of each optical unit. The variation (non-uniformity) in characteristics of the respective optical units cause variation in widths of patterns to be formed by exposures performed by the respective optical units.

Therefore, it can be said that if a plurality of optical unit is provided without comprising means for compensating characteristics of the respective optical units, exposure in a pattern faithful to the pattern data cannot be performed on the panel substrate.

Therefore, the above mentioned arrangement comprises compensation means for compensating, according to the characteristics of the corresponding optical unit, the control signal to be sent to the corresponding optical unit from the control means. Thus, in each optical unit, the width of pattern to be formed by exposure is adjusted according to the control signal which is compensated according to its characteristics.

This allows each optical unit to adjust, according to the control signal in which the characteristics of each optical unit are compensated, the width of pattern to be formed by exposure . Hereby, it is possible to perform exposure on the panel substrate in a pattern faithful to the pattern data, regardless of the characteristics of each optical unit.

In addition to the above arrangement, the pattern exposing apparatus in accordance with the present invention is arranged such that each optical unit comprises a focus servo control section for adjusting a focus position of the light condensing lens in an optical axial direction according to the control signal.

As the focus position of the light condensing lens to the position on the photosensitive material is moved in the optical axial direction, the beam width on the photosensitive material changes, and thus the width of pattern to be formed by exposure also changes. Therefore, in the arrangement in which the focus servo control means adjusts the focus position of the light condensing lens according to the control signal sent to the optical unit in the optical axial direction, it is possible to control, according to the control signal, the width of pattern to be formed by exposure.

In this respect, in the above mentioned the Patent Document 1, no mechanism for controlling an exposure pattern width is provided. Therefore, a pattern can be exposed always with constant width. However, according to the above mentioned arrangement, a width of pattern to be formed by exposure can be controlled. Therefore, by generating pattern data in variety of forms it is possible to expose a pattern in variety of forms.

In addition to the above arrangement, the pattern exposing apparatus in accordance with the present invention is arranged such that each optical unit comprises: an intensity changing section for adjusting, according to the control signal, intensity of the laser light to be emitted from the light source.

The laser light which has intensity above a certain degree causes photoreaction of the photosensitive material. Moreover, a change in the intensity of the laser light emitted from the laser light source cause a change in a width of an area in which the photoreaction of the photosensitive material occurs, and thus the width of pattern to be formed by exposure also changes. Therefore, By adjusting the intensity of the laser light emitted from the light source according to the control signal, it becomes possible to control, according to the control signal, the width of pattern to be formed by exposure.

A method in accordance with the present invention is a pattern exposing method for exposing a photosensitive material in accordance with a pattern in a scanning manner by using a pattern exposing apparatus comprising a plurality of optical units having (i) a light source for emitting laser light for the exposure in the scanning manner and (ii) a light condensing lens for condensing the laser light onto the photosensitive material applied on a panel substrate. To solve the foregoing problems, the method comprises the steps of: transmitting, respectively to each optical unit, a control signal according to pattern data concerning a target pattern, the control signal being for controlling a width of pattern to be formed by exposure; and compensating individually the control signals according to characteristics of the corresponding optical units, the control signals being to be transmitted from the control section to the corresponding optical units.

The pattern exposing apparatus comprises the plurality of optical units. Here, each optical unit has variation in characteristics of the light source. Moreover, each optical unit has variation in the adjustment errors in positioning an optical element therein. Furthermore, characteristics of the optical element provided in each optical unit are various. Here, the characteristics of the light source, the adjustment error in positioning the optical element in each optical unit, and the characteristics of the optical element are dependent on the characteristics of each optical unit. The variation (non-uniformity) in characteristics of the respective optical units causes variation in widths of patterns to be formed by exposures performed by the respective optical units.

Therefore, it can be said that if each of a plurality of optical units exposes a pattern without including a procedure of compensating characteristics of each optical unit, exposure in a pattern faithful to the pattern data cannot be performed on the panel substrate.

To solve the problem, the above mentioned procedure comprises the step of compensating the control signal sent from the control means to each optical unit according to the characteristics of the corresponding optical unit. Thus, each optical unit adjusts, according to the control signal which is compensated according to characteristics of the corresponding optical unit, width of pattern to be formed by exposure.

This allows each optical unit to adjust, according to the control signal in which the characteristics of the corresponding optical unit are compensated, the width of pattern to be formed by exposure. Hereby, exposure in a pattern faithful to the pattern data can be performed on the panel substrate, regardless of the characteristics of each optical unit.

In addition to the above procedure, the pattern exposing method in accordance with the present invention is arranged such that a focus position of the light condensing lens is individually adjusted according to the control signal corresponding thereto in an optical axial direction, so as to control a width of pattern to be formed by exposure performed by the optical unit corresponding thereto.

As the focus position of the light condensing lens to the position on the photosensitive material is moved in the optical axial direction, the beam width on the photosensitive material changes, and thus the width of pattern to be formed by exposure also changes. Therefore, by adjusting the focus position of the light condensing lens according to the control signal sent to the optical unit in optical axial direction, it is possible to control, according to the control signal, the width of pattern to be formed by exposure.

In addition to the above procedure, the pattern exposing method in accordance with the present invention is arranged such that intensity of the laser light emitted from the light source is individually adjusted according to the control signal corresponding thereto, so as to control a width of pattern to be formed by exposure performed by the optical unit corresponding thereto.

The laser light which has intensity equal to or higher than a certain intensity causes the photoreaction of the photosensitive material. Moreover, a change in the intensity of the laser light emitted from the light source causes a change in a width of an area in which the photoreaction of the photosensitive material occurs, and thus the width of pattern to be formed by exposure also changes. Therefore, by adjusting the intensity of the laser light emitted from the laser light source according to the control signal, it is possible to control, according to the control signal, the width of pattern to be exposed.

In addition to the above procedure, the pattern exposing method in accordance with the present invention is so arranged as to include the steps of: when an optical axis of the light condensing lens intersects with an exposure position on the photosensitive material, adjusting the intensity of the laser light to intensity enough to cause the photosensitive material to be photo-reacted; and when the optical axis of the light condensing lens intersects with a non-exposure position on the photosensitive material, adjusting the intensity of the laser light to intensity less than the intensity enough to cause the photosensitive material to be photo-reacted.

When the light source is turned on/off to control exposure/non-exposure of the pattern, focusing is required after the light source is turned on. During the period required for the focusing, a non-exposure state occurs even in the exposure position. In this case, during the period which is necessary for focusing, scanning is performed, and so a problem occurs that the scanning is performed on the exposure position without exposing a pattern.

To solve the problem, according to the foregoing procedure, when an optical axis of the light condensing lens intersects with an exposure position on the photosensitive material, the intensity of the laser light is adjusted to the intensity enough to cause the photosensitive material to be photo-reacted. This makes it possible to perform pattern exposure on the exposure position. Moreover, when the optical axis of the light condensing lens intersects with a non-exposure position on the photosensitive material, the intensity of the laser light is adjusted to the intensity less than the intensity enough to cause the photosensitive material to be photo-reacted. With this step, it is possible to maintain a state in which a pattern is not exposed, while the laser light is emitted in the non-exposure position.

In this method, it is possible to control exposing/non-exposing of pattern simply by adjusting the intensity without turning off the laser light emitted from the light source.

Therefore, since there is no need to control the exposure/non-exposure of a pattern by turning on/off the laser light emitted from the light source, it is possible to perform the focusing during the period for scan exposure. With this method, it is possible to avoid the problem. That is, since there is no need to control the exposure/non-exposure of the pattern by turning on/off the laser light from the light source, it is possible to perform focusing at any time during the scan exposure. With this method, it is possible to avoid the problem.

In addition to the foregoing procedure, the pattern exposing method in accordance with the present invention arranged such that a width of pattern to be formed by exposure performed by the optical unit which is equal to or narrower than a target minimum exposure pattern width when the light condensing lens is in a focusing state.

Widening the exposure pattern width of the exposure of the photosensitive material can be realized by moving the focal position of the light condensing lens away from the photosensitive material. On the other hand, narrowing the exposure pattern width can be realized by moving the focus point of the light condensing lens toward the photosensitive material. That is, when the light condensing lens is in the focus state (focusing state), the width of pattern to be formed by exposure by the optical unit has a minimum width. However, in the arrangement in which the exposure has a target minimum exposure pattern width in the focus state the exposure would not be possibly carried out in the target minimum pattern width in case where degradation of the light condensing performance occurs due to the variation in the characteristics of the optical unit.

Therefore, with the arrangement in which, when the light condensing lens is in the focusing state, the width of pattern to be formed by exposure by the optical unit is equal to or narrower than the target minimum exposure pattern width (i.e. the minimum exposure width has an allowance), it is possible to prevent disadvantage that the exposure cannot be performed in a targeted pattern if the light condensing performance is degraded due to the variation in characteristics of the optical unit.

Moreover, the embodiments above discusses the cases in which data transferring means 22, control means 23, and a compensation operation memory 24 as compensation means are hardware. The present invention, however, is not limited to these arrangements. All or a part of each member can be realized by combination of a program for realizing the function and hardware (computer) for executing the program. As an example, the data transferring means 22, the control means 23, and the compensation means can be realized by using a computer as a device driver for driving the pattern exposing apparatus 30, the computer connected to a pattern exposing apparatus 30.

The present invention is not limited to each embodiment mentioned above. Various changes can be made within the scope of the claims. An embodiment according to a proper combination of technical means disclosed in different embodiments is encompassed in the technical scope of the present invention.

The invention being thus described, it will be obvious that the same may be varied in many ways. Such variations are not to be regarded as a departure from the spirit and scope of the invention, and all such modifications as would be obvious to one skilled in the art intended to be included within the scope of the following claims.

INDUSTRIAL APPLICABILITY

The present invention is especially appropriate in the steps of performing pattern exposure for wiring or the like on a large area panel substrate in fabrication of flat type display apparatus such as a liquid crystal panel. However, the present invention is not limited to liquid crystal panel substrate, but is suitably used in steps for exposing for a wiring pattern on the substrate for a variety of electronic circuits.

**Claims**

1. A pattern exposing apparatus, comprising:

   optical units, each of which has (i) a light source for emitting laser light for exposure in a scanning manner and (ii) a light condensing lens for condensing the laser light onto a photosensitive material applied on a panel substrate; and
   a control section for transmitting, respectively to each optical unit, a control signal according to pattern data concerning a target pattern, the control signal being for controlling a width of pattern to be formed by exposure,
   each optical unit respectively exposing the photosensitive material to form a pattern according to the control signal in the scanning manner,
   the pattern exposing apparatus further comprising:

      a compensation section for compensating individually the control signals according to characteristics of the corresponding optical units, the control signals being to be transmitted from the control section to the corresponding optical units.

2. The pattern exposing apparatus according to claim 1, wherein:

   each optical unit comprises a focus servo control section for adjusting a focus position of the light condensing lens in an optical axial direction according to the control signal.

3. The pattern exposing apparatus according to claim 1, wherein:

   each optical unit comprises:

      a focus error detection section for detecting focus error of the light condensing lens; and
      a focus servo control section for adjusting a focus position of the light condensing lens in an optical axial direction according to the focus error and the control signal.

**4.** The pattern exposing apparatus according to claim 3 wherein:

each optical unit comprises:

a light-receiving section for receiving light emitted from the light source and reflected on the photosensitive material, the focus servo control section compensating the focus position of the light condensing lens according to a total amount of light received by the light-receiving element.

**5.** The pattern exposing apparatus according to one of claims 1 through 4, wherein:

each optical unit comprises:

an intensity changing section for adjusting, according to the control signal, intensity of the laser light to be emitted from the light source.

**6.** The pattern exposing apparatus according to claim 5 comprising:

a monitor section for monitoring the intensity of the laser light emitted from the light source, the intensity changing section compensating the intensity of the laser light according to an output from the monitor section.

**7.** A pattern exposing method for forming a pattern by exposure on a photosensitive material being scanned, the exposure is performed by using a pattern exposing apparatus comprising a plurality of optical units having (i) a light source for emitting laser light for the exposure in the scanning manner and (ii) a light condensing lens for condensing the laser light onto the photosensitive material applied on a panel substrate, the method comprising the steps of:

transmitting, respectively to each optical unit, a control signal according to pattern data concerning a target pattern, the control signal being for controlling a width of pattern to be formed by exposure; and compensating individually the control signals according to characteristics of the corresponding optical units, the control signals being to be transmitted from the control section to the corresponding optical units.

**8.** The pattern exposing method according to claim 7, wherein:

a focus position of the light condensing lens is individually adjusted according to the control signal corresponding thereto in an optical axial direction, so as to control a width of pattern to be formed by exposure performed by the optical unit corresponding thereto.

**9.** The pattern exposing method according to claim 7 or 8, wherein:

intensity of the laser light emitted from the light source is individually adjusted according to the control signal corresponding thereto, so as to control a width of pattern to be formed by exposure performed by the optical unit corresponding thereto.

**10.** The pattern exposing method according to claim 9, comprising steps of:

when an optical axis of the light condensing lens intersects with an exposure position on the photosensitive material, adjusting the intensity of the laser light to intensity enough to cause the photosensitive material to be photo-reacted; and when the optical axis of the light condensing lens intersects with a non-exposure position on the photosensitive material, adjusting the intensity of the laser light to intensity less than the intensity enough to cause the photosensitive material to be photo-reacted.

**11.** The pattern exposing method according to any one of claims 7 through 10, wherein:

a width of pattern to be formed by exposure performed by the optical unit is equal to or narrower than a target minimum exposure pattern width when the light condensing lens is in a focusing state.

**12.** A pattern exposing apparatus comprising:

(I) optical units, each of which includes (i) a light source for emitting laser light, and (ii) a light condensing lens for condensing the laser light onto a photosensitive material applied on a panel substrate, and each of which performs exposure in a scanning manner on the panel substrate by the laser light;
(II) a control section for transmitting, respectively to each optical unit, a control signal according to pattern data concerning a target exposure pattern, the control signal being for controlling driving of the corresponding optical unit,

(III) a compensation section for compensating individually the control signals according to characteristics of the corresponding optical units, the control signals being to be inputted into the corresponding optical units.

FIG. 1

FIG. 2

FIG. 3

14

18                17

19                20

FIG. 4

14

18                17

19                20

FIG. 5

———— FOCUSING STATE

----- DEFOCUSING STATE

E 2

E 1

PANEL SUBSTRATE
SURFACE

x 1

x 2

FIG. 6

FES

V

d

−d

AMOUNT OF DEFOCUS

−V

FIG. 7

FES

V′

AMOUNT OF DEFOCUS

d′

FIG. 8

FES

AMOUNT OF DEFOCUS

V′

d 1

d 2

FIG. 9

------- I 2
——— I 3

E 2

E 1

PANEL SUBSTRATE
SURFACE

x 3

x 4

FIG. 10

FIG. 11

FIG. 12

E 2

E 1

FIG. 13

15  14   5                    24

16              13          25     2

101             12              4    3    2

6

7

9
8

10

11

## INTERNATIONAL SEARCH REPORT

| | International application No. |
|---|---|
| | PCT/JP2004/007687 |

A. CLASSIFICATION OF SUBJECT MATTER
    Int.Cl$^7$  G03F7/20, H01L21/30

According to International Patent Classification (IPC) or to both national classification and IPC

B. FIELDS SEARCHED

Minimum documentation searched (classification system followed by classification symbols)
    Int.Cl$^7$  G03F7/20, H04N1/04-1/207, B41J2/435-2/48, G02B26/10-26/12

Documentation searched other than minimum documentation to the extent that such documents are included in the fields searched
    Jitsuyo Shinan Koho          1922-1996   Jitsuyo Shinan Toroku Koho   1996-2004
    Kokai Jitsuyo Shinan Koho    1971-2004   Toroku Jitsuyo Shinan Koho   1994-2004

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2000-214597 A  (Sharp Corp.),<br>04 August, 2000 (04.08.00),<br>Full text; all drawings<br>(Family: none) | 1-12 |
| Y | JP 5-290720 A  (Sony Corp.),<br>05 November, 1993 (05.11.93),<br>Full text; all drawings<br>(Family: none) | 1-12 |
| Y | JP 2003-211633 A  (Agfa Corp.),<br>29 July, 2003 (29.07.03),<br>Full text; all drawings<br>& US 2003/133132 A1 | 2-6,8-11 |

[X] Further documents are listed in the continuation of Box C.    [ ] See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search<br>16 August, 2004 (16.08.04) | Date of mailing of the international search report<br>31 August, 2004 (31.08.04) |
|---|---|
| Name and mailing address of the ISA/<br>Japanese Patent Office | Authorized officer |
| Facsimile No. | Telephone No. |

Form PCT/ISA/210 (second sheet) (January 2004)

23

<div align="center">

**INTERNATIONAL SEARCH REPORT**

</div>

| | International application No. |
|---|---|
| | PCT/JP2004/007687 |

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2-8809 A (Asahi Optical Co., Ltd.), 12 January, 1990 (12.01.90), Page 2, lower right column, line 13 to page 4, lower left column, line 13; Figs. 1 to 8 & US 5055663 A | 2-6,8-11 |
| Y | JP 2-304515 A (Canon Inc.), 18 December, 1990 (18.12.90), Page 3, lower left column, line 4 to page 4, upper left column, line 13; Fig. 2 (Family: none) | 2-6,8-11 |
| Y | JP 2-188276 A (Canon Inc.), 24 July, 1990 (24.07.90), Page 2, lower right column, line 18 to page 3, upper left column, line 16; Figs. 1, 2 (Family: none) | 1-12 |
| Y | JP 62-49315 A (Konishiroku Shashin Kogyo Kabushiki Kaisha), 04 March, 1987 (04.03.87), Page 1, lower right column, line 15 to page 2, upper left column, line 2; page 2, lower left column, line 20 to lower right column, line 9; Figs. 1 to 4 & US 4763134 A        & DE 3628915 A & GB 2180684 A | 1-12 |
| Y | JP 59-146068 A (Nippon Telegraph & Telephone Public Corp.), 21 August, 1984 (21.08.84), Page 2, upper left column, line 13 to lower left column, line 2; Figs. 2 to 4 (Family: none) | 1-12 |
| Y | JP 61-277259 A (Toshiba Corp.), 08 December, 1986 (08.12.86), Claims; page 3, lower left column, line 5 to lower right column, line 5; Fig. 4 (Family: none) | 1-12 |
| Y | JP 2003-140355 A (Dainippon Screen Mfg. Co., Ltd.), 14 May, 2003 (14.05.03), Par. Nos. [0072] to [0074]; Figs. 14, 15 & US 2003/085985 A1        & EP 1311108 A2 | 5,6,9-11 |
| A | JP 2001-125285 A (Toshiba Corp.), 11 May, 2001 (11.05.01), Par. Nos. [0018] to [0025]; Figs. 1, 2 (Family: none) | 1-12 |

Form PCT/ISA/210 (continuation of second sheet) (January 2004)

**INTERNATIONAL SEARCH REPORT**

| | International application No. |
|---|---|
| | PCT/JP2004/007687 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2002-341551 A   (Fuji Photo Film Co., Ltd.), 27 November, 2002 (27.11.02), Par. Nos. [0038] to [0041]; Fig. 14 & US 2002/126200 A1 | 1-12 |
| A | JP 2002/131675 A   (Fuji Photo Film Co., Ltd.), 09 May, 2002 (09.05.02), Abstract (Family: none) | 1-12 |
| A | JP 3-239598 A  (Jujo Seishi Kabushiki Kaisha), 25 October, 1991 (25.10.91), Figs. 1, 2 (Family: none) | 1-12 |

Form PCT/ISA/210 (continuation of second sheet) (January 2004)